# EUROPÄISCHE PATENTSCHRIFT

(11) **EP 0 771 472 B1**
(45) Veröffentlichungstag und Bekanntmachung des Hinweises auf die Patenterteilung: **26.07.2000**
(21) Anmeldenummer: 96905709.0
(22) Anmeldetag: 12.03.1996
(51) Int. Cl.: H01L 21/60

(54) **VERFAHREN ZUM VERBINDEN EINES ELEKTRISCHEN ANSCHLUSSES EINES UNVERPACKTEN IC-BAUELEMENTS MIT EINER LEITERBAHN AUF EINEM SUBSTRAT**
PROCESS FOR CONNECTING AN ELECTRIC CONNECTION OF AN UNPACKED IC COMPONENT TO A CONDUCTIVE TRACK ON A SUBSTRATE
PROCEDE DE RACCORDEMENT D'UNE CONNEXION ELECTRIQUE D'UN COMPOSANT CI NON MIS SOUS BOITIER AVEC UN TRACE CONDUCTEUR SUR UN SUBSTRAT

(30) Priorität: 20.05.1995 DE 19518659
(43) Veröffentlichungstag der Anmeldung: 07.05.1997
(73) Patentinhaber: ROBERT BOSCH GMBH, 70442 Stuttgart (DE)
(72) Erfinder: GRÜNWALD, Werner, D-70839 Gerlingen (DE); HAUG, Ralf, D-71229 Leonberg (DE); SEYFFERT, Martin, D-31139 Hildesheim (DE); HAUSCHILD, Frank-Dieter, D-31134 Hildesheim (DE)
(86) Internationale Anmeldenummer: DE9600432
(87) Internationale Veröffentlichungsnummer: WO9636991

(56) Entgegenhaltungen:
- EP-A- 0 463 297
- EP-A- 0 475 022
- EP-A- 0 493 131
- DE-A- 4 008 624
- US-A- 3 811 186
- US-A- 4 642 889
- US-A- 5 056 215

## Beschreibung

### Stand der Technik

Die Erfindung betrifft ein Verfahren zum Verbinden eines elektrischen Anschlusses eines unverpackten IC-Bauelements mit einer Leiterbahn auf einem Substrat entsprechend der Gattung des Anspruchs 1. In der WO 94/05139 ist ein Verfahren zur Herstellung feinstrukturierter elektrisch leitfähiger Schichten auf einem Substrat beschrieben, bei dem zwecks Verbesserung der Strukturfeinheit und Kantenschärfe eine dünne Aktivierungsschicht (Bekeimung) mit der gewünschten Schichtstruktur aufgebracht, und dann an die Bekeimung eine dickere Leitschicht aus elektrisch leitendem Metall, beispielsweise Kupfer (Cu) oder Nickel (Ni), angelagert wird. Die Anlagerung erfolgt durch die Abscheidung aus einem galvanischen Bad oder stromlos aus einem Reduktionsbad.

Bei üblichen Verbindungstechniken zur Montage eines IC-Bauelements auf einem Substrat wurden Leiterbahnen auf der von dem IC-Bauelement abgekehrten Seite des Substrates aufgebracht und mit Kontaktflächen versehen. Zur Verbindung des IC-Bauelementes mit den Kontaktflächen der Leiterbahnen sind Durchbohrungen des Substrates und der Leiterbahnen vorhanden, auf die die IC-Bauelemente mit ihren Anschlußflächen positioniert werden. Somit überdeckt jede Anschlußfläche die dazugehörige Bohrung. Anschließend werden die Kontakt- und Anschlußflächen chemisch mit einem Metall verstärkt, bis die Metallschichten in der Durchbohrung zusammenwachsen und die elektrische Verbindung entsteht. Nachteilig an dieser Verbindungstechnik ist, daß man nur dünne Substrate bei mäßigen Temperaturbelastungen einsetzen kann. Die Herstellung der Durchbohrungen des Substratmaterials ist mechanisch aufwendig und teuer. Häufig sind nur bestimmte Substratmaterialien verwendbar.

Ein weiteres Verfahren zum elektrischen Verbinden von beispielsweise IC-Bauelementen mit einem Substrat wurde in dem US-Patent 4,642,889 offenbart. Dort wird während der Montage der IC-Bauelemente auf dem Substrat als Abstandshalter zunächst ein vorzugsweise in Wasser lösliches Papier aufgebracht, das im Bereich der zu kontaktierenden Flächen Löcher aufweist, in denen sich ein Lötmittel und Kupferfäden befinden. Danach werden die IC-Bauelemente auf dem Abstandhalter positioniert und mit dem Substrat durch Wärmezufuhr im Bereich der Löcher verlötet. Abschließend wird das Papier als Abstandshalter durch Abwaschen entfernt. Der Nachteil dieses Verfahrens liegt in der erforderlichen hohen lokalen Wärmezufuhr beim Löten empfindlicher Bauteile, im relativ großen Abstand der Verbindungspunkte (Lötstellen) und in der exakten Positionierung des vorgefertigten, mit Löchern versehenen Abstandshalters auf dem Substrat.

Die Offenlegungsschrift EP 0 475 022 A1 offenbart einen technisch sehr aufwendigen Prozeß zur elektrischen Verbindung von Chips mit einem Substrat, wobei als Abstandshalter zunächst eine thermoplastische, dielektrische Folie auf einen Chip aufgebracht wird, die an den elektrisch zu kontaktierenden Stellen über Bohren oder eine Laserablation strukturiert wird. Die elektrische Verbindung zwischen Chip und Substrat wird über ein Polyimidsiloxanpolymer vorgenommen, dem eine Paste mit Metallteilchen, bevorzugt Goldkolloide, beigemischt wird und das anschließend nach dem Zusammenfügen der Bauteile bei einer Temperatur oberhalb des Transformationspunktes des Polymers bzw. der Folie wärmebehandelt wird. Die Nachteile dieses Verfahrens sind die relativ hohen anzuwendenden Temperaturen, die anfallenden Kosten für die Metallpaste und der technisch aufwendige Prozeß mit seinen vielen Verfahrensschritten.

### Vorteile der Erfindung

Das erfindungsgemäße Verfahren mit den Merkmalen des Hauptanspruchs hat den Vorteil, daß Durchbohrungen in der engen Anordnung der IC-Anschlüsse im Substrat entfallen. Die Dicke des einsetzbaren Substratmaterials ist somit nicht begrenzt. Einseitig strukturierte Substrate sind möglich. Dünne Substrate oder Foliensubstrate erleiden keine Schwächung des Substratwerkstücks. Das Verfahren erlaubt die Verwendung aller ungehäusten integrierten Schaltkreise (IC's), während andere Flip-Chip-Techniken meist auf speziell vorbehandelte (gebumpte) IC's eingeschränkt sind. Es lassen sich sehr kurze leitende Verbindungen mit guter thermischer Leitfähigkeit und verbesserten Hochfrequenzeigenschaften von erfindungsgemäß verbundenen Substraten mit den dazugehörigen Bauelementen ausführen. Eine Schädigung empfindlicher Eauelemente durch Erhitzung beim Löten wird eliminiert und Kunststoffteile können näher am Substrat liegend angeordnet werden. Eine Automatisierung des Verfahrens ist möglich. Durch eine Verkleinerung des Abstandes nebeneinanderliegender Anschlüsse des IC-Bauelementes gegenüber verpackten Bauelementen läßt sich Substratmaterial und Material für die Leiterbahn und die isolierenden Schichten bei vergleichbarem Nutzungsumfang der Schaltung einsparen.

Durch die in den Unteransprüchen angegebenen Maßnahmen werden weitere Verbesserungen und Vorteile gegenüber dem Stand der Technik erreicht. Von besonderer Qualität sind durch Abscheidung eines elektrisch leitenden Stoffs gewonnene Kontaktverbindungen. Die Ausfüllung des freien Volumens zwischen den zu kontaktierenden Flächen gelingt besonders gut mit Nickel- oder Kupfersalzlösungen in galvanischen Bädern, wobei die Stromdichte frei einstellbar und während der Herstellung veränderbar ist. Eine alternative Abscheidung gelingt mit metallhaltigen Reaktionslösungen, die ein Reduktionsmittel wie Hydrazin (oder Formaldehyd) aufweisen und über den Handel bezogen werden. Es ist üblich, die Konzentrationen vor der Abscheidung geeignet zu wählen oder bei der Abscheidung Reduktionsmittel oder metallhaltige Lösungen zuzuführen. Zur Erhöhung der Fertigungsstückzahlen sind zu verbindende Kontaktflächen der Leiterbahn-Landeflächen vorzubehandeln, um die Reaktion und Kristallisation bevorzugt auf die zu verbindenden Teile zu lenken und unerwünschte Konkurrenzreaktionen zu vermeiden. Durch das Aufbringen großflächiger passivierender Schichten wird die spätere elektrische Isolation des Produktes verbessert und Materialvergeudung bei der Abscheidung leitfähiger Stoffe ausgeschlossen. Wegen der niedrigen Temperaturen beim Abscheiden tritt unerwünschte Diffusion in den Kontaktstellen nicht nennenswert auf.

### Zeichnung

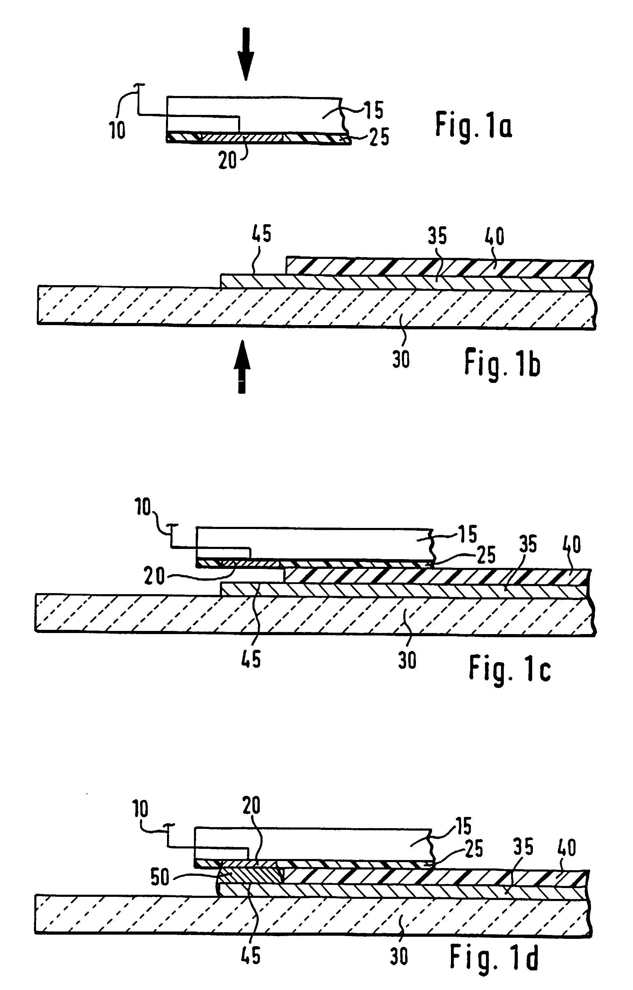

Die Erfindung ist anhand eines Beispiels mit Bezug auf die beiliegenden Zeichnungen erläutert. Figur la zeigt ein unverpacktes IC-Bauelement, Figur 1b ein vorbereitetes Substrat, Figur 1c die Positionierung des IC-Bauelements auf dem Substrat, und Figur 1d ein IC-Bauelement auf dem Substrat.

In Figur 1a ist ein elektrischer Anschluß 10 eines unverpackten IC-Bauelements 15 gezeichnet. Die zu kontaktierende Oberfläche des Anschlusses 10 weist eine gut metallisierbare Schicht 20 auf. Zur Isolierung und zum mechanischen Schutz ist die Oberfläche seitlich der Anschlüsse 10 mit einer passivierenden Schicht 25 umgeben.

Figur 1b zeigt ein Substrat 30 mit einer die Oberfläche teilweise abdeckenden Leiterbahn 35, auf die eine Abstandshalterung 40 derart aufgebracht ist, daß als Landefläche 45 auf der Leiterbahn 35 eine freie, elektrisch kontaktierbare Oberfläche bleibt.

Figur lc zeigt ein IC-Bauelement nach Figur la auf einem Substrat nach Figur 1b, wobei die zu kontaktierenden Flächen 20, 45 einander zugekehrt sind. Eine geeignete Positionierung wird erreicht, wenn Substrat 30 und IC-Bauelement 15 gemäß den Pfeilen der Figuren 1a und 1b derart aufeinandergesetzt werden, daß die Flächen der metallisierbaren Schicht 20 und der Landefläche 45 sich berührungsfrei gegenüberliegen.

Figur 1d zeigt die Verbindung eines IC-Bauelements 15 mit einem Substrat 30. Der elektrisch leitende Stoff 50 füllt das freie Volumen zwischen Landefläche 45 und metallisierbarer Schicht 20 aus.

### Beispiel 1

Auf die zu kontaktierende Oberfläche eines elektrischen Anschlusses 10 wird eine Palladium-Keime enthaltende Paste in Dickschichttechnik als metallisierbare Schicht 20 aufgebracht. Parallel wird auf ein Aluminiumoxid-Substrat 30 eine Kupfer-Leiterbahn 35 mit einem üblichen Verfahren, beispielsweise dem in der DE 35 37 161 A1 = US-PS 4 780 332 beschrieben, aufgebracht. Die Kupfer-Leiterbahn 35 wird, mit Ausnahme der Kupfer-Landeflächen 45 mit einer isolierenden Schicht, zum Beispiel einer Epoxidharzschicht, als Abstandshalterung 40 überzogen, wobei deren Dicke auf der Leiterbahn 35 genau eingestellt wird. Es wird, wie in Figur 1c gezeichnet, positioniert und durch gleichzeitiges chemisches Abscheiden von Nickel auf der Palladium-Keime aufweisenden metallisierbaren Schicht 20 und der Kupfer-Landefläche 45 Nickel, nach einer in der WO 94/05139 beschriebenen Methode, als leitender Stoff 50 abgeschieden. Die Abscheidung erfolgt, bis die gegenüberliegenden Nickelbeläge zusammenwachsen und eine elektrische Verbindung des Anschlusses 10 mit der Leiterbahn 35 entsteht. Das Ende des Zusammenwachsens wird zum Beispiel durch Beurteilung der Tropfenform oder Widerstandsmessung der Verbindung kontrolliert. Anstelle des IC-Bauelements läßt sich auch ein anderes elektrisches Bauelement verwenden.

### Beispiel 2

Es wird gleichzeitig eine Vielzahl von Anschlüssen 10 des IC-Bauelementes 15 mit Leiterbahnen 35 verbunden, sonst wird wie in Beispiel 1 vorgegangen.

### Beispiel 3

Das Substrat 30 wird nur einseitig beschichtet, wobei die unbeschichtete Seite bei einem ausreichend dicken Substrat die äußere Gehäusewand eines Gerätes bildet, auf dessen Innenwand das IC-Bauelement 15 angebracht ist, sonst wird wie in Beispiel 1 gefertigt.

### Beispiel 4

Die Bekeimung der metallisierbaren Schicht 20 nach Beispiel 1 entfällt, sonst wird gemäß Beispiel 1 gearbeitet.

### Beispiel 5

Die Paste zur Bekeimung der metallisierbaren Schicht 20 wird bei sehr kleinen Anschlußrastern im Tampondruckverfahren aufgebracht.

### Beispiel 6

Werden mehrere Verbindungen gemäß Beispiel 1 und 2 gefertigt, so reicht es aus, die Abstandshalterung 40 bei den peripheren Leiterbahnen 35 des Substrates 30 oder wenigstens bei drei auseinanderliegenden Leiterbahnen vorzusehen.

### Beispiel 7

Zur Bekeimung können Edelmetalle wie Pt, Rh, Pd, Ru, Rh, Au, Ag, Ir, Os, Re oder Edelmetallegierungen eingesetzt werden, sonst wird wie in Beispiel 1 verfahren.

### Beispiel 8

Alternativ zu den vorhergehenden Beispielen werden die in der folgenden Tabelle genannten Materialien eingesetzt:

| Teil | verwendbare Materialien |
|---|---|
| elektrischer Anschluß 10, 20 oder Leiterbahn 35 | Al, Cu, Ni, Ag, Au, Ag/Au-Legierung, Graphit, Pd leitender Kunststoff Ag/Pd, Sn, Pt, Rh, Ru, Ir, Os, Re |
| Abstandshalterung 40 | PVC, Polyurethan, Epoxidharz, Isolierlack, Polyimid, Acrylharz, Acrylathaltige Epoxid-Systeme |
| Substrat 30 | Aluminiumoxid-Keramik, Epoxid, Keramik, Polyamid, Aramid, Porzellan, Si, Pertinax, Polyester, Polyimid, Leiterplatten-Material, ALN-Keramik |
| leitfähiger Stoff 50 | Ni, Cu, Ag, Au, Sn, Pd Legierungen dieser Stoffe |

## Patentansprüche

1. Verfahren zum Verbinden eines elektrischen Anschlusses (10) eines unverpackten IC-Bauelementes (15) mit einer Leiterbahn (35) auf einem Substrat (30), wobei auf die zu kontaktierende Oberfläche (10) des IC-Bauelementes (15) eine metallisierbare Schicht (20) aufgebracht ist, auf die Leiterbahn (35) außerhalb einer Landefläche (45) zunächst eine Abstandshalterung (40) aufgebracht wird, dann die zu kontaktierende Oberfläche (10, 20) des IC-Bauelements (15) und die Leiterbahn (35) des Substrats (30) einander mit einem der Abstandshalterung entsprechenden Abstand zugekehrt werden und schließlich auf die Landefläche (45) der Leiterbahn (35) und die zu kontaktierende Oberfläche (10, 20) des IC-Bauelements (15) simultan ein elektrisch leitfähiger Stoff (50) zum Ausfüllen des freien Volumens zwischen den beiden zu kontaktierenden Flächen (10, 20, 45) aufgebracht wird.

2. Verfahren nach Anspruch 1, dadurch gekennzeichnet, daß die Abscheidung des elektrisch leitfähigen Stoffes (50) aus einem galvanischen Bad oder stromlos aus einem Reduktionsbad ausgeführt wird.

3. Verfahren nach Anspruch 1 oder 2, dadurch gekennzeichnet, daß als elektrischer leitfähiger Stoff (50) Nickel (Ni) abgeschieden wird.

4. Verfahren nach einem der vorhergehenden Ansprüche, dadurch gekennzeichnet, daß Substrate (30) verwendet werden, die nur einseitig eine Leiterbahnebene aufweisen.

5. Verfahren nach einem der vorhergehenden Ansprüche, dadurch gekennzeichnet, daß die Oberfläche des IC-Bauelements (15) auf der dem Substrat (30) zugekehrten Seite mit einer passivierenden Schicht (25) überzogen wird, wobei die zu kontaktierende Oberfläche (10) unvergütet bleibt.

6. Verfahren nach einem der vorhergehenden Ansprüche, dadurch gekennzeichnet, daß zumindest die Landefläche (45) der Leiterbahn aus Kupfer (Cu) hergestellt wird.

7. Verfahren nach einem der vorhergehenden Ansprüche, dadurch gekennzeichnet, daß die Abstandshalterung (40) zwischen dem IC-Bauelement (15) und der Leiterbahn (35) aus wenigstens einem aufgedruckten Abstandshalter (40) hergestellt wird.

## Claims

1. Process for connecting an electrical terminal (10) of an unpacked IC component (15) to a conductor track (35) on a substrate (30), a metallizable layer (20) being applied to that surface (10) of the IC component (15) with which contact is to be made, a spacer element (40) being initially applied to the conductor track (35) outside a land (45), that surface (10, 20) of the IC component (15) with which contact is to be made and the conductor track (35) of the substrate (30) facing one another with a space corresponding to the spacer element, and simultaneously an electrically conductive material (50) for filling the free volume between the two spaces (10, 20, 45) which are to be placed in contact being applied to the land (45) of the conductor track (35) and to that surface (10, 20) of the IC component (15) with which contact is to be made.

2. Process according to Claim 1, characterized in that the deposition of the electrically conductive material (50) is carried out from an electrolytic bath or in an electroless fashion from a reduction bath.

3. Process according to Claim 1 or 2, characterized in that nickel (Ni) is deposited as the electrically conductive material (50).

4. Process according to one of the preceding claims, characterized in that the substrates (30) used have a conductor track plane on one side only.

5. Process according to one of the preceding claims, characterized in that the surface of the IC component (15) is coated on the side facing away from the substrate (30) with a passivating layer (25), the surface (10) with which contact is to be made remaining untreated.

6. Process according to one of the preceding claims, characterized in that at least the land (45) of the conductive track is fabricated from copper (Cu).

7. Process according to one of the preceding claims, characterized in that the spacer element (40) between the IC component (15) and the conductor track (35) is fabricated from at least one printed-on spacer (40).

## Revendications

1. Procédé pour relier un raccordement électrique (10) d'un composant de circuit imprimé (15), non mis sous boîtier à une piste conductrice (35) sur un substrat (30),
dans lequel
- on dépose sur la surface à mettre en contact (10) du composant de circuit imprimé (15) une couche métallisable (20),
- on dépose tout d'abord sur la piste conductrice (35) en dehors d'une surface de pose (45) un écarteur (40),
- la surface à mettre en contact (10, 20) du composant de circuit imprimé (15) et la piste conductrice (35) du substrat (30) tournées l'une vers l'autre à une distance correspondant à l'écarteur, et
- enfin on dépose simultanément sur la surface de pose (45) de la piste conductrice (35) et sur la surface à mettre en contact (10, 20) du composant de circuit imprimé (15), une matière électriquement conductrice (50) servant à remplir le volume libre compris entre les deux surfaces à mettre en contact (10, 20, 45).

2. Procédé selon la revendication 1,
caractérisé en ce que
la précipitation de la matière électriquement conductrice (50) est effectuée à partir d'un bain électrolytique, ou sans courant à partir d'un bain de réduction.

3. Procédé selon la revendication 1 ou 2,
caractérisé en ce qu'
on précipite comme matière électriquement conductrice (50) du nickel (Ni).

4. Procédé selon l'une des revendications précédentes,
caractérisé en ce qu'
on utilise des substrats (30), qui ne présentent une piste conductrice plane que d'un côté.

5. Procédé selon l'une des revendications précédentes,
caractérisé en ce que
la surface du composant de circuit imprimé (15) est revêtu sur le côté tourné vers le substrat (30) d'une couche de passivation (25), la surface (10) à mettre en contact restant non traitée.

6. Procédé selon l'une des revendications précédentes,
caractérisé en ce qu'
au moins la surface de pose (45) de la piste conductrice est réalisée en cuivre (Cu).

7. Procédé selon l'une des revendications précédentes,
caractérisé en ce que
l'écarteur (40) qui se trouve entre le composant de circuit imprimé (15) et la piste conductrice (35) est réalisé à partir d'au moins un écarteur (40) imprimé.
